# EUROPEAN PATENT APPLICATION

(11) **EP 4 435 457 A1**
(43) Date of publication of application: **25.09.2024**
(21) Application number: 23165496.3
(22) Date of filing: 30.03.2023
(51) Int. Cl.: G01R 33/3415, G01R 33/48, G01R 33/36, G01R 33/54, G01R 33/565

(54) **MAGNETIC RESONANCE RECEIVER COIL ARRAY WITH INTEGRATED ULTRASOUND TRANSDUCER**

(30) Priority: 22.03.2023 US 202363453782 P
(71) Applicant: Koninklijke Philips N.V., 5656 AG Eindhoven (NL)
(72) Inventor: OUZOUNOV, Sotir Filipov, Eindhoven (NL); VAN DEN BRINK, Johan Samuel, Eindhoven (NL); ERRICO, Claudia, 5656AG Eindhoven (NL); BHARAT, Shyam, Eindhoven (NL); MANKOVICH, Gabriel, Eindhoven (NL); PREVRHAL, Sven Peter, Eindhoven (NL)
(74) Representative: Philips Intellectual Property & Standards

(57) **Abstract**

According to the invention, a magnetic resonance (MR) receiver coil array (1) for an imaging system is provided, the MR receiver coil array (1) comprising
at least one radio frequency (RF) receiver antenna (2),
at least one digital amplifier signal acquisition unit (3), wherein the digital amplifier signal acquisition unit (3) is configured to receive an MR signal from the RF receiver antenna (2) and to output digital amplified MR data,
at least one ultrasound transducer (5), wherein the ultrasound transducer (5) is acoustically couplable to an examination object (6),
at least one ultrasound signal acquisition unit (7), wherein the ultrasound signal acquisition unit (7) is configured to receive an ultrasound signal from the ultrasound transducer (5) and to output digital ultrasound data, and
a digital control and merge unit (8) comprising a controller module (9) and a merger module (10), wherein
the controller module (9) is configured to generate control signals comprising a first control signal for the MR digital amplifier signal acquisition unit (3) and a second control signal for the ultrasound signal acquisition unit (7), and
the merger module (10) is configured to receive the digital amplified MR data and the digital ultrasound data and to output the digital MR data and the digital ultrasound data to a digital data processing unit configured to combine the digital MR data and the digital ultrasound data to optimize the data acquisition and/or to optimize the image reconstruction.

In this way, a possibility to combine and coordinate ultrasound imaging and MR imaging with each other for an improved image quality is provided.

## Description

### FIELD OF THE INVENTION

The invention relates to the field of magnetic resonance receiver coil arrays, and in particular to a magnetic receiver coil array with an additional and integrated ultrasound transducer.

### BACKGROUND OF THE INVENTION

Magnetic resonance (MR) imaging as well as ultrasound imaging are common medical imaging modalities. A combination of MR and ultrasound imaging can bring a plurality of enhancements towards improved image quality for each of the modalities taken separately. For example, the MR imaging can be used to establish the types of tissues in the field of view of the ultrasound probe thus providing information to the ultrasound imaging for calculation of the local ultrasound velocities in each different type of tissue and their subsequent compensation during ultrasound image reconstruction. Similarly, there are known techniques for the enhancement of MR image acquisition based on ultrasound data. In a typical example, organs and blood movement is established with ultrasound separately and the motion data is subsequently used in the MR image reconstruction to remove motion artifacts and enhance the MR image, but without accurate time alignment. Further, in some clinical cases for example foetal scan, deep vessels imaging etc., the in-body motion cannot be detected in any other way as, for example, electrophysiology measurements or surface motion measurements via camera or radar that are successfully used for motion measurement of the body surface. Ultrasound imaging device can achieve a sufficient depth. Further, with ultrasound, accurate flow assessment can be made thus not only motion measurements, but also detailed quantifications of the motion can be made.

Typically, the ultrasound imaging front-end is completely separated from the MR imaging equipment as it is simply impossible to integrate them together in one system.

WO01/43640 A2 describes a diagnostic imaging system, notably a magnetic resonance imaging system comprising a receiver antenna for picking-up magnetic resonance signals and an ultrasound probe for receiving ultrasound echoes. A reconstruction unit is arranged to reconstruct a diagnostic image from the magnetic resonance signals and the ultrasound echoes. In particular, the magnetic resonance image and ultrasound images are registered in a common reference time frame and/or geometric distortions in the ultrasound image are corrected on the basis of the magnetic resonance image.

### SUMMARY OF THE INVENTION

It is an object of the invention to provide a possibility to combine and coordinate ultrasound imaging and MR imaging with each other for an improved image quality.

According to the invention, this object is addressed by the subject matter of the independent claims. Preferred embodiments of the invention are described in the sub claims.

Therefore, according to the invention, a magnetic resonance (MR) receiver coil array for an imaging system, the MR receiver coil array comprising at least one radio frequency (RF) receiver antenna, at least one digital amplifier signal acquisition unit, wherein the digital amplifier signal acquisition unit is configured to receive an MR signal from the RF receiver antenna and to output digital amplified MR data, at least one ultrasound transducer, wherein the ultrasound transducer is acoustically couplable to an examination object, at least one ultrasound signal acquisition unit, wherein the ultrasound signal acquisition unit is configured to receive an ultrasound signal from the ultrasound transducer and to output digital ultrasound data, and a digital control and merge unit comprising a controller module and a merger module, wherein the controller module is configured to generate control signals comprising a first control signal for the MR digital amplifier signal acquisition unit and a second control signal for the ultrasound signal acquisition unit, the merger module is configured to receive the digital amplified MR data and the digital ultrasound data and to output the digital MR data and the digital ultrasound data to a digital data processing unit configured to combine the digital MR data and the digital ultrasound data to optimize the data acquisition and/or to optimize the image reconstruction.

The proposed invention provides the possibility to process MR data and ultrasound (US) data at the same time with an accurate time alignment. According to a common time base, for example through coordinated control signals, the physiological measurements and images can be corelated in time.

To "optimize the data acquisition and/or the image reconstruction" means preferably that the combination of the digital data does not have to be on an image level. To "optimize the data acquisition" means that for example the measurement from the ultrasound acquisition can be used to modify the MR sequence or parameters. To "optimize the image reconstruction" means preferably that two images, namely MR and US images, can be used separately or overlapped. The essential point is, that both images comprise the same time frame. They can be evaluated separately or fused.

In respect to the currently used solutions, the invention enables a minimization of the footprint of the US imaging hardware in the MR bore, because the US hardware is integrated and shares for example the controller unit and the power supply. Therefore, the invention enables a minimization of the impact on the MR image quality. Further, the invention simplifies the design for safety and electromagnetic compatibility of a combined MR/US image acquisition system.

As a result, the costs of the additional ultrasound imaging are low as the ultrasound specific hardware is limited. Further, the preparation of the patient for dual imaging is simple and quick and can be easily incorporated in the MR imaging flow.

The extremely accurate alignment of MR and ultrasound operation enables multiple new use-cases of the combined imaging. For example, cardiac imaging can be performed simultaneously such that the MR scan is creating a volumetric image while ultrasound is used for flow imaging and quantification. The time-aligned combination of MR and US imaging decreases the scan time significantly while improving the diagnostic capabilities.

Preferably, the digital control and merge unit comprises a digital state machine that generates aligned control signals for the MR and ultrasound imaging units according to a user program. It also contains digital hardware e.g. an FPGA device that comprises at least one digital transceiver such that a digital data network can be built. Further preferred, it has many digital transceivers one of which can support high data throughput as needed by the ultrasound imaging probe in some use-cases. Further preferred, the digital control and merge unit uses an accurate timing reference e.g. crystal oscillator that is propagated towards the MR signal acquisition unit and the ultrasound probe, and to preferably also to the MR transmission coils. The same timing reference or a derivative from it is used for a retiming of the incoming MR and Ultrasound data such that fully time-aligned data streams are generated and propagated for backend processing and image reconstruction.

Preferably, the digital control and merge unit contain features to generate ultrasound images locally or to process locally the ultrasound data. For example, flow information can be extracted and used locally to adapt the MR transmission sequence or MR data acquisition. The digital control and merge unit comprises further preferably a wireless device with battery power and wireless communication.

According to a preferred embodiment of the invention, the digital data processing unit is further configured to receive position information of the at least one radio frequency (RF) receiver antenna, position information of the at least one ultrasound transducer and a topology of the at least one radio frequency (RF) receiver antenna and of the at least one ultrasound transducer, and to reconstruct a composition image according to the position information of the radio frequency antenna, the position information of the ultrasound transducer and the topology of the radio frequency antenna and the ultrasound transducer. The topology describes the specific arrangement of devices and lines that make up a computer network through which computers are interconnected and exchange data. The integrated US transducer and the MR coil array's configuration is known to the data processing unit. In this way, especially for a flexible coil array and/or a variable geometry of the ultrasound transducer, the position of the radio frequency (RF) receiver antenna and of the ultrasound transducer as well as the topology of the components are known for a better reconstruction. The position of the transducer is determined by both the RF coil's sensitivity profiles, spatially uniquely encoded by the MR gradients. Together with the mutual topology of the RF coil element and the ultrasound transducer, the MR-informed positional information are used for the image reconstruction.

According to a preferred embodiment of the invention, the merger module is configured to align the timing of outputting the digital amplified MR data and/or of the digital ultrasound data. In this way, the transmission of MR and US signals can be time-aligned, especially according to a pre-described clinical procedure. For example, ultrasound can be used to establish and track the dynamics of the heart movement and subsequently be used as a trigger to an MR imaging sequence such that the MR Transmitter is aligned with a particular cardiac phase or movement.

According to a preferred embodiment of the invention, the merger module is configured to align the timing of receiving the digital amplified MR data and/or the digital ultrasound data. In this way, the reception of MR and/or US signals can be time-aligned, especially according to a pre-described clinical procedure. The ultrasound receiver can look at the same object as the MR receiver, for example at the heart valve, or assess similar aspects, for example morphology or different flow quantifications.

According to a preferred embodiment of the invention, the controller module is configured to generate a predetermined sequence of the first control signal and the second control signal. In this way, sequences are defined that control an MR and/or US signal in different sequences or intervals, especially according to a pre-described clinical procedure.

According to a preferred embodiment of the invention, the controller module is configured to evaluate the digital ultrasound data and to adjust the first control signal according to the evaluation of the digital ultrasound data. In this way, in a first step, knowledge can be gained from the ultrasound data that will influence the subsequent MR scan. The operation of the MR digital amplifier signal acquisition unit is especially dynamically adjusted according to the evaluated ultrasound data.

According to a preferred embodiment of the invention, the controller module is configured to evaluate the digital MR data and to adjust the second control signal according to the evaluation of the digital amplified MR data. In this way, in a first step, knowledge can be gained from the MR data that will influence the subsequent US scan. The operation of the ultrasound signal acquisition unit is especially dynamically adjusted according to the evaluated MR data.

According to a preferred embodiment of the invention, the magnetic resonance receive coil array comprises a plurality of radio frequency (RF) receiver antennas and a plurality of digital amplifier signal acquisition units that are interconnected via a digital network connected with the digital control and merge unit. The digital amplifier signal acquisition units are interconnected to form a ring network by means of a digital network.

According to a preferred embodiment of the invention, the ultrasound signal acquisition unit is connected with the digital network and/or with the digital control and merge unit. The ultrasound signal acquisition unit is integrated into the infrastructure, especially into the data, control and/or power supply infrastructure, of the MR receiver coil array. The ultrasound signal acquisition unit is integrated in the MR receive coil array and connected to the MR coil power supply and digital network. Especially, if the ultrasound acquisition is constructed such that it generates more receive data than the coil network can transport, a dedicated read-out optical cable to the digital control and merge unit is used for data transport. Such an optical cable will not impact the MR compatibility of the ultrasound integration.

According to a preferred embodiment of the invention, each radio frequency (RF) receiver antenna comprises at least one ultrasound transducer. One or more ultrasound probes are integrated in each MR receive coil element. The MR signal localization, necessary for MR image reconstruction, is especially used to localize the US signal origin. Joint detection also allows the development of combined processing algorithms to enhance sensitivity and specificity beyond the capabilities of each single modality. Especially, the MR receiver coil array comprises tight-fitting MR coils, for example for carotids or wearable coils, according to the need for ultrasound to make direct skin contact.

Preferably, the ultrasound transducer is coupled via water-based gel to the patient. The acoustic coupling is introduced especially via semi-rigid gels on the designated area on the patient before the MR receiver coil array is positioned on the patient. In this case the complete ultrasound probe is build-in the MR coil assembly. Alternatively, the ultrasound transducer is preferably attached to the patient and is connected to the rest of the ultrasound acquisition in the MR receiver coil array via a simple, short cable. Alternatively, the complete ultrasound acquisition and digitization unit is preferably integrated in a device that is prepositioned on the patient and digital interfaces can be used to plug it in the MR coil.

The invention further relates to a method for acquiring measurement data with an MR receiver coil array described above, the method comprising the following method steps:
generating control signals comprising a first control signal for the MR digital amplifier signal acquisition unit and a second control signal for the ultrasound signal acquisition unit and providing the first control signal to the MR digital amplifier signal acquisition unit and the second control signal to the ultrasound signal acquisition unit,
receiving an MR signal from the RF receiver antenna and outputting digital amplified MR data with the digital amplifier signal acquisition unit,
receiving an ultrasound signal from the ultrasound transducer and outputting digital ultrasound data with the ultrasound signal acquisition unit,
receiving the digital amplified MR data and the digital ultrasound data with the merger module, and
outputting the digital amplified MR data and the digital ultrasound data to a digital data processing unit combining the digital MR data and the digital ultrasound data to optimize the data acquisition and/or to optimize the image reconstruction.

It is an essential point of the invention, that both signals, the MR signal and the US signal are used to generate a combined image, especially a volume-coverage US image.

According to a preferred embodiment of the invention, the method comprises the following method steps:
providing position information of the at least one radio frequency (RF) receiver antenna (2),
providing position information of the at least one ultrasound transducer (5),
providing a topology of the at least one radio frequency (RF) receiver antenna (2) and of the at least one ultrasound transducer (5), and
reconstruct a composition image according to the position information of the radio frequency antenna, the position information of the ultrasound transducer (5) and the topology of the radio frequency antenna (2) and the ultrasound transducer (5).

In this way, the use of a flexible receive coil array and/or variable ultrasound transducer geometries are possible. The position information and the topology are received and known by the digital data processing unit that reconstruct the composition image, especially a volumetric ultrasound image.

According to a preferred embodiment of the invention, the method comprises the following method steps:
merging the digital amplified MR data and the digital ultrasound data with the merger module, and outputting merged MR and ultrasound data to a digital data processing unit.

The digital MR and digital US data is merged and outputted in a time-aligned manner. "Merging" means to combine the signals according to the location and/or origin and/or timestamp of the signal.

According to a preferred embodiment of the invention, the method comprises the following method steps:
evaluating the digital ultrasound data and adjusting the first control signal according to the evaluation of the digital ultrasound data, or
evaluating the digital MR data and adjusting the second control signal according to the evaluation of the digital amplified MR data.

The invention further relates to a magnetic resonance (MR) imaging device comprising a magnetic resonance (MR) receiver coil array described above.

The invention further relates to a computer program product comprising instructions to cause the magnetic resonance (MR) receiver coil array describes above to execute the steps of the method described above.

### BRIEF DESCRIPTION OF THE DRAWINGS

These and other aspects of the invention will be apparent from and elucidated with reference to the embodiments described hereinafter. Such an embodiment does not necessarily represent the full scope of the invention, however, and reference is made therefore to the claims and herein for interpreting the scope of the invention.

In the drawings:
Fig. 1 schematically depicts an MR receiver coil array comprising multiple digital RF amplifier and an ultrasound transducer according to an embodiment of the invention,
Fig. 2 schematically depicts an MR receiver coil array comprising an ultrasound transducer with the data flow according to an embodiment of the invention,
Fig. 3 shows a flow chart of a method for acquiring measurement data with an ultrasound transducer in a magnetic resonance (MR) receiver coil array according to an embodiment of the invention.

### DETAILED DESCRIPTION OF EMBODIMENTS

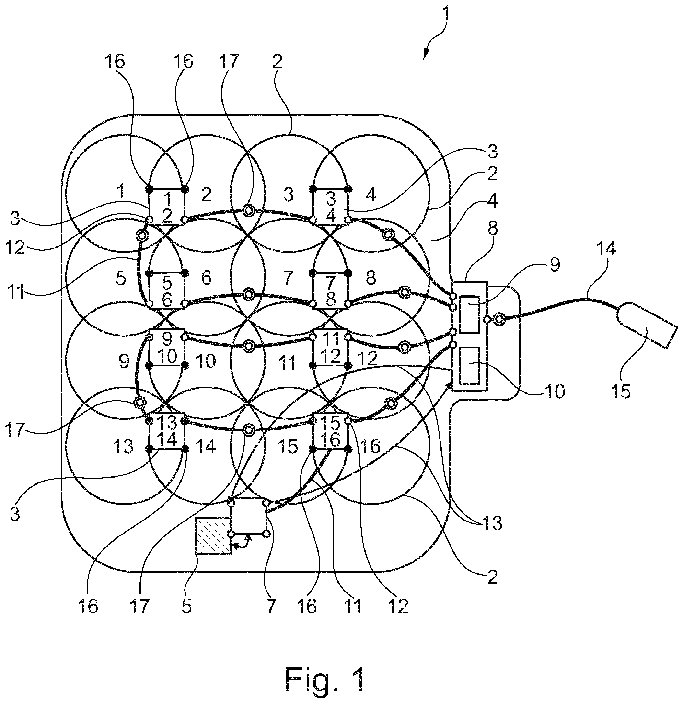

Fig. 1 schematically depicts an MR receiver coil array 1 comprising multiple digital amplifiers and multiple sensor nodes. Fig. 1 shows an example of a 16-channel MR receiver coil array 1. The MR receiver coil array 1 consists of 16 radio frequency (RF) receive antennas 2, with 2 of each of the (RF) receive antennas 2 interconnected with a digital amplifier signal acquisition unit 3. Fig. 1 shows that the MR receiver coil array 1 is housed in coil array housing 4 and can be connected to the back-end of the imaging system, for example, by means of a coil cable 14 and a coil plug 15. Four of the digital amplifier signal acquisition units 3 are interconnected via coil loop connections 16 to form a ring network of digital amplifier signal acquisition units 3. The digital amplifier signal acquisition units 3 are interconnected by means of a digital network 11 and connected to the digital network 11 via digital network connections 12. For blocking high frequency noise in galvanic cables common mode RF chokes 17 can be introduced in the digital network 11. If the digital network is optical common mode RF chokes 17 are not needed. Each of the digital amplifier signal acquisition unit 3 is configured for receiving an MR signal from the RF receiver antenna 2 and outputting a digital amplified MR signal. The network of digital amplifier signal acquisition unit 3 forwards the digital amplified MR signals to a digital control and merge unit 8 comprising a controller module 9 and a merger module 10 where the data from the individual channels is combined to a single data stream. The single data stream is further transmitted via the coil cable 14 to the backend of the digital data processing unit outside the MR receive coil array where the image reconstruction is done.

The MR receiver coil array 1 further comprises an ultrasound transducer 5 that is connected with an ultrasound acquisition unit 7. The ultrasound acquisition unit 7 is connected via the same digital network 11 with the digital control and merge unit 8. Therefore, the ultrasound acquisition unit 7 is integrated in the infrastructure of the MR receiver coil array 1. For a higher data transmission possibility, the ultrasound acquisition unit 7 can be directly connected via an optical link 13 with the digital control and merge unit 8. The ultrasound acquisition unit 7 is configured for receiving an ultrasound signal from the ultrasound transducer 5 and outputting a digital ultrasound signal to the digital control and merge unit 8. The merger module 10 combines the MR data and the ultrasound data. The combined data is further transmitted via the coil cable 14 to data processing unit 23 where the image reconstruction is done.

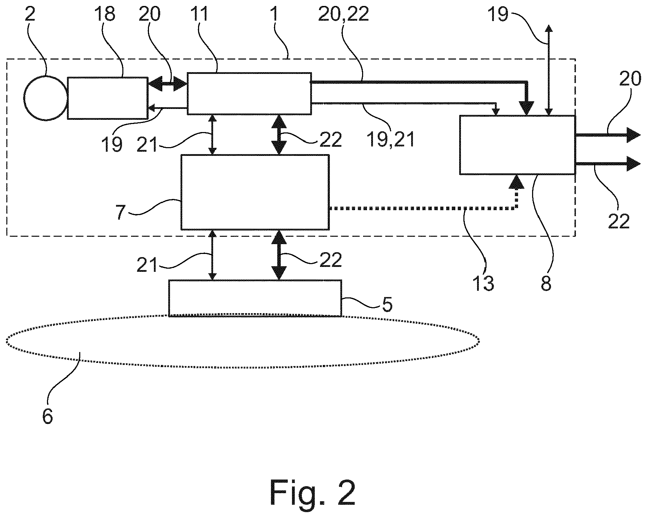

Fig. 2 schematically depicts a MR receiver coil array 1 with its components and data transfer. The MR receiver coil array 1 comprises RF receive antennas 2 that are connected with a digital amplifier module 18. The digital amplifier module 18 is interconnected with the digital network 11. From the digital network 11 the digital amplifier module 18 receives a MR control signal 19. The digital amplifier module 18 transmits MR data 20 from the RF receive antenna via the digital network 11 to the digital control and merge unit 8. The ultrasound acquisition unit 7 is connected with the digital network 11 and the ultrasound transducer 5 and can receive and transmit an ultrasound control signal 21 and ultrasound data 22 from and to the digital network 11 and the ultrasound transducer 5. The ultrasound transducer is outside the MR receiver coil array 1 and is placed directly on the examination object 6. For a proper operation, the ultrasound transducer 5 is coupled via water-based gel to the examination object 6. The acoustic coupling can be introduced via semi-rigid gels on the designated area on the examination object 6 before the MR receiver coil array 1 is positioned on the examination object 6. In this case the complete ultrasound probe is build-in the MR receiver coil array 1. Via the digital network 11 the ultrasound data 22 is transferred to the digital control and merge unit 8. Alternatively, the ultrasound data 22 can be transferred via the optical link 13 to the digital control and merge unit 8. The digital control and merge unit 8 provides a MR signal 20 and an ultrasound signal 22 that are coordinated with each other. The digital control and merge unit 8 is configured to evaluate the MR and/or ultrasound signal and to adjust the MR and/or ultrasound control signal according to the evaluation.

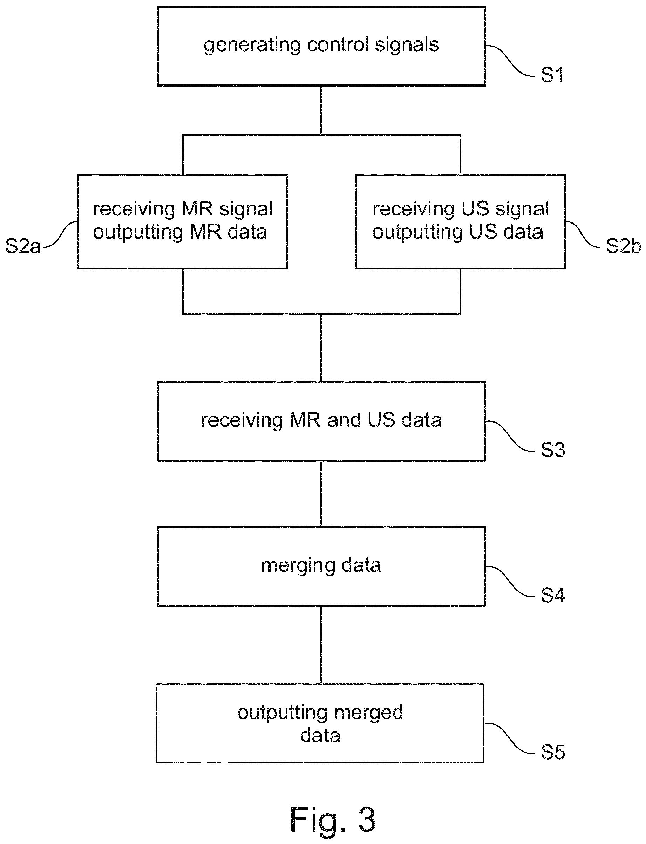

Fig. 3 shows a flow chart of a method for A method for acquiring measurement data with an MR receiver coil array 1 according to a preferred embodiment of the invention. In step S1 control signal are generated. The control signals comprise a first control signal for the MR digital amplifier signal acquisition unit 3 and a second control signal for the ultrasound signal acquisition unit 7. The control signals are provided for the respective acquisition unit. In step S2a the MR signal is received from the RF receiver antenna 2 and outputted as digital MR data 20 with the digital amplifier signal acquisition unit 3. In step S2b the ultrasound signal is received from the ultrasound transducer 5 and outputted as digital ultrasound data 22 with the ultrasound signal acquisition unit 7. After the MR and ultrasound data is transmitted, it is received with the merger module 10 of the digital control and merge unit 8 in step S3. In step S4 the merger module 10 merges the data, especially by combining the data according to the location and/or origin and/or timestamp of the signal. In step S5 the merged data is outputted to a digital data processing unit that generates a combined image.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope. Further, for the sake of clearness, not all elements in the drawings may have been supplied with reference signs.

### REFERENCE SYMBOL LIST

| | |
|---|---|
| MR receiver coil array | 1 |
| RF receive antenna | 2 |
| digital amplifier signal acquisition unit | 3 |
| coil array housing | 4 |
| ultrasound transducer | 5 |
| examination object | 6 |
| ultrasound acquisition unit | 7 |
| digital control and merge unit | 8 |
| controller module | 9 |
| merger module | 10 |
| digital network | 11 |
| digital network connection | 12 |
| optical link | 13 |
| coil cable | 14 |
| coil plug | 15 |
| coil loop connection | 16 |
| common mode RF choke | 17 |
| digital amplifier module | 18 |
| MR control signal | 19 |
| MR data | 20 |
| ultrasound control signal | 21 |
| ultrasound data | 22 |

## Claims

1. A magnetic resonance (MR) receiver coil array (1) for an imaging system, the MR receiver coil array (1) comprising
at least one radio frequency (RF) receiver antenna (2),
at least one digital amplifier signal acquisition unit (3), wherein the digital amplifier signal acquisition unit (3) is configured to receive an MR signal from the RF receiver antenna (2) and to output digital amplified MR data,
at least one ultrasound transducer (5), wherein the ultrasound transducer (5) is acoustically couplable to an examination object (6),
at least one ultrasound signal acquisition unit (7), wherein the ultrasound signal acquisition unit (7) is configured to receive an ultrasound signal from the ultrasound transducer (5) and to output digital ultrasound data, and
a digital control and merge unit (8) comprising a controller module (9) and a merger module (10), wherein
the controller module (9) is configured to generate control signals comprising a first control signal for the MR digital amplifier signal acquisition unit (3) and a second control signal for the ultrasound signal acquisition unit (7), and
the merger module (10) is configured to receive the digital amplified MR data and the digital ultrasound data and to output the digital MR data and the digital ultrasound data to a digital data processing unit configured to combine the digital MR data and the digital ultrasound data to optimize the data acquisition and/or to optimize the image reconstruction.

2. The magnetic resonance (MR) receive coil array (1) according to claim 1, wherein the digital data processing unit is further configured to receive position information of the at least one radio frequency (RF) receiver antenna (2), position information of the at least one ultrasound transducer (5) and a topology of the at least one radio frequency (RF) receiver antenna (2) and of the at least one ultrasound transducer (5), and to reconstruct a composition image according to the position information of the radio frequency antenna (2), the position information of the ultrasound transducer (5) and the topology of the radio frequency antenna (2) and the ultrasound transducer (5).

3. The magnetic resonance (MR) receive coil array (1) according to claim 1 or 2, wherein merger module (10) is configured to align the timing of outputting the digital amplified MR data and/or of the digital ultrasound data.

4. The magnetic resonance (MR) receive coil array (1) according to any of the previous claims, wherein merger module (10) is configured to align the timing of receiving the digital amplified MR data and/or the digital ultrasound data.

5. The magnetic resonance (MR) receive coil array (1) according to any of the previous claims, wherein the controller module (9) is configured to generate a predetermined sequence of the first control signal and the second control signal.

6. The magnetic resonance (MR) receive coil array (1) according to any of the previous claims, wherein the controller module (9) is configured to evaluate the digital ultrasound data and to adjust the first control signal according to the evaluation of the digital ultrasound data.

7. The magnetic resonance (MR) receive coil array (1) according to any of the previous claims, wherein the controller module (9) is configured to evaluate the digital MR data and to adjust the second control signal according to the evaluation of the digital amplified MR data.

8. The magnetic resonance (MR) receive coil array (1) according to any of the previous claims, wherein the magnetic resonance receive coil array (1) comprises a plurality of radio frequency (RF) receiver antennas (2) and a plurality of digital amplifier signal acquisition units (3) that are interconnected via a digital network (11) connected with the digital control and merge unit (8).

9. The magnetic resonance (MR) receive coil array (1) according to claim 8, wherein the ultrasound signal acquisition unit (7) is connected with the digital network (11) and/or with the digital control and merge unit (8).

10. A method for acquiring measurement data with an MR receiver coil array (1) according to one of the previous claims, the method comprising the following method steps:
generating control signals comprising a first control signal for the MR digital amplifier signal acquisition unit (3) and a second control signal for the ultrasound signal acquisition unit (7) and providing the first control signal to the MR digital amplifier signal acquisition unit (3) and the second control signal to the ultrasound signal acquisition unit (7),
receiving an MR signal from the RF receiver antenna (2) and outputting digital amplified MR data with the digital amplifier signal acquisition unit (3),
receiving an ultrasound signal from the ultrasound transducer (5) and outputting digital ultrasound data with the ultrasound signal acquisition unit (7),
receiving the digital amplified MR data and the digital ultrasound data with the merger module (10), and
outputting the digital amplified MR data and the digital ultrasound data to a digital data processing unit combining the digital MR data and the digital ultrasound data to optimize the data acquisition and/or to optimize the image reconstruction.

11. The method according to claim 10, with the following further method steps:
providing position information of the at least one radio frequency (RF) receiver antenna (2),
providing position information of the at least one ultrasound transducer (5),
providing a topology of the at least one radio frequency (RF) receiver antenna (2) and of the at least one ultrasound transducer (5), and
reconstruct a composition image according to the position information of the radio frequency antenna, the position information of the ultrasound transducer (5) and the topology of the radio frequency antenna (2) and the ultrasound transducer (5).

12. The method according to claim 10 or 11, with the following further method steps:
merging the digital amplified MR data and the digital ultrasound data with the merger module (10), and outputting merged MR and ultrasound data to a digital data processing unit.

13. The method according to one of the claims 10 to 12, with the following further method steps:
evaluating the digital ultrasound data and adjusting the first control signal according to the evaluation of the digital ultrasound data, or
evaluating the digital MR data and adjusting the second control signal according to the evaluation of the digital amplified MR data.

14. A magnetic resonance (MR) imaging device comprising a magnetic resonance (MR) receiver coil array (1) according to one of the claims 1 to 10.

15. A computer program product comprising instructions to cause the magnetic resonance (MR) receiver coil array (1) of one of claims 1 to 10 to execute the steps of the method of one of the claims 10 to 13.
